(19)

Europäisches Patentamt
European Patent Office
Office européen des brevets

(11) **EP 4 310 526 A1**

(12) **EUROPEAN PATENT APPLICATION**

(43) Date of publication:
**24.01.2024 Bulletin 2024/04**

(21) Application number: **22315164.8**

(22) Date of filing: **22.07.2022**

(51) International Patent Classification (IPC):
**G01R 33/00** (2006.01)

(52) Cooperative Patent Classification (CPC):
**G01R 33/0035**; G01R 33/0029; G01R 33/07;
G01R 33/09

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
- **CROCUS TECHNOLOGY SA
  38025 Grenoble (FR)**
- **Crocus Technology Inc.
  Milpitas, CA 95035 (US)**

(72) Inventors:
- **SERRANO GUISAN, Santiago
  San Jose, CA 95120 (US)**
- **ATES GURCAN, Hakan
  Los Gatos, CA 95032 (US)**
- **ALAOUI, Ali
  38210 Polienas (FR)**
- **MOHAN, Anuraag
  Fremont, CA 94536 (US)**
- **AERABI, Ehsan
  38700 La Tronche (FR)**

(74) Representative: **P&TS SA (AG, Ltd.)
  Avenue J.-J. Rousseau 4
  P.O. Box 2848
  2001 Neuchâtel (CH)**

(54) **CORRECTION METHOD FOR CORRECTING THE OUTPUT VOLTAGE OF A MAGNETIC SENSOR**

(57) The present disclosure concerns a correction method for correcting an output voltage signal provided by a magnetic sensor, comprising: providing a sensor, comprising at least a magnetoresistive element, inputting the sensor by a bias voltage in the presence of the external magnetic field vector such that the sensor generates the output voltage signal; and determining a corrected output voltage signal from the output voltage signal, where the corrected output voltage signal has a linearity error smaller than the linearity error of the output voltage signal. The corrected output voltage signal is determined by applying a hyperbolic function or an inverse hyperbolic function or a combination of a hyperbolic function or an inverse hyperbolic function, to a signal proportional to the output voltage signal, or to an additional voltage signal being added or subtracted to the output voltage signal.

$V_{out} = V_{out+} - V_{out-}$

Fig. 1

EP 4 310 526 A1

## Description

### Technical domain

The present disclosure concerns a correction method for correcting an output voltage signal provided by a magnetic sensor in the presence of an external magnetic field. The present disclosure further concerns an integrated circuit (IC) configured to perform the method.

### Related art

Linear magnetic sensors have many consumer, industrial and automotive applications. Current sensing, positioning, proximity detection, biometric sensing are some examples. Sensor technologies using Magnetic Tunnel Junctions (MTJs) based on Tunnel Magneto-Resistance (TMR) effect excel among rival technologies based on Anisotropic Magneto-Resistance (AMR) effect, Giant Magneto-Resistance (GMR) effect and Hall effect, thanks to their higher sensitivity and signal-to-noise ratio (SNR), lower temperature dependence, better long-term stability and generally smaller die size.

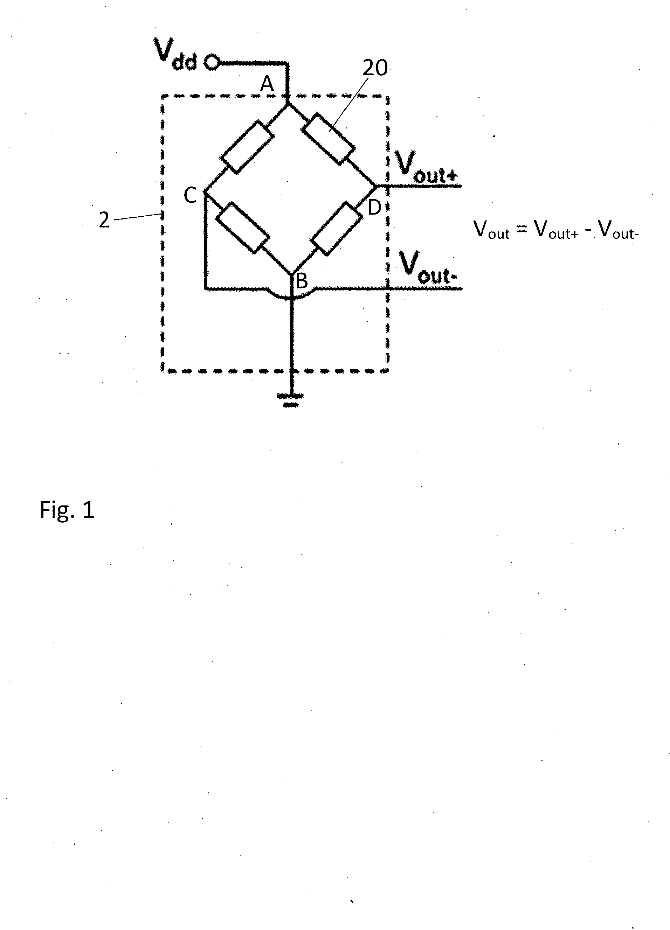

Fig. 1 shows an exemplary magnetic sensor 2 comprising four magnetic sensing elements 20 arranged in a full-bridge circuit, such as a Wheatstone bridge circuit. The magnetic sensing element 20 can comprise a magnetoresistive element, such as a MTJ.

Commonly, a magnetic sensor provides a differential output voltage signal $V_{out}$ ($V_{out} = V_{out}+ - V_{out}-$) that is roughly proportional to external applied magnetic field. However, the larger the magnetic field is, the larger is the deviation of $V_{out}$ from a perfect linear response.

The linearity of such magnetic sensor can generally be improved by the development of novel magnetic stacks enabling larger working magnetic field ranges. However, the improvement in linearity usually comes at the expense of a reduction of sensor sensitivity.

Some approaches were previously proposed to improve the linearity of such magnetic sensor without reduction of sensitivity. Such previous schemes were based either on piece-wise linear correction or by continuous compensation of next high order terms of the output voltage signal $V_{out}$. Piece-wise linear correction can comprise segmentation of the overall output voltage signal $V_{out}$ response at different magnetic field ranges while continuous compensation of non-linearity relies on continuous addition of an extra voltage to the output voltage signal $V_{out}$.

A typical response of a magnetic sensor inputted by a bias voltage $V_{dd}$ and under an external magnetic field H can be approximated by equation 1:

$$V_{out} = v_s(H) \cdot V_{dd} \qquad \text{Eq. 1,}$$

with

$$v_s(H) = a_0 + a_1 \cdot H + \sum_{j=1}^{N} (-1)^j \cdot a_{2j+1} \cdot H^{2j+1} \qquad \text{Eq. 2,}$$

where $v_s$ expresses the intrinsic dependence of the magnetic sensor when submitted to an external magnetic field (i.e., the normalized output voltage of the sensor), $a_0$ is the sensor offset, $a_1$ is a linear coefficient (or Sensitivity) and $a_{2j+1}$ are the high order components, respectively. Usually, $a_1 \gg a_{2j+1}$, being each high order coefficient much larger than the next one. This implies that the larger is the working magnetic field range of the sensor the larger will be the impact of high order components on sensor's response, i.e., the output voltage signal $V_{out}$.

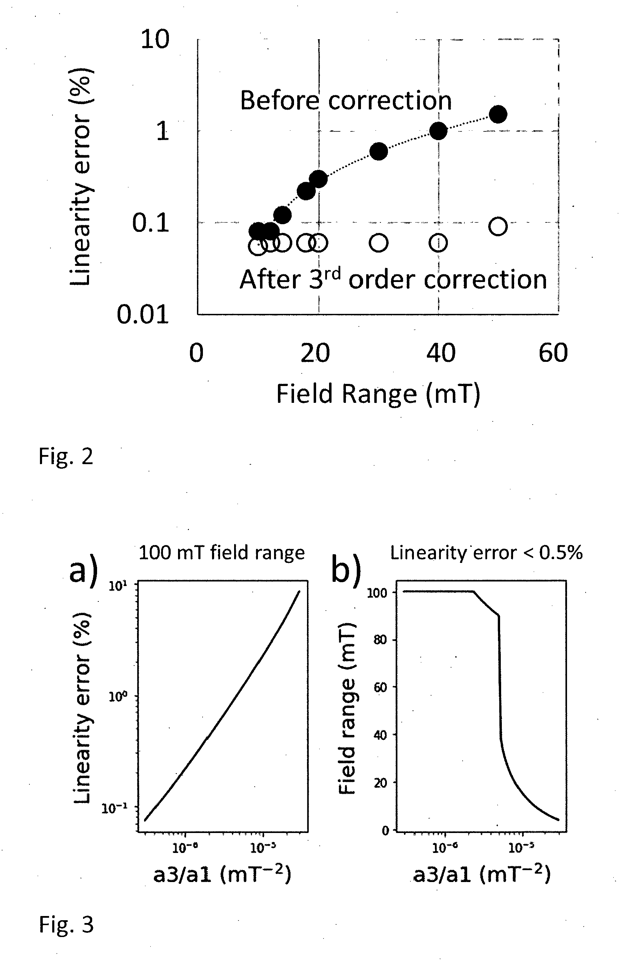

Fig. 2 shows the linearity error derived from a magnetic sensor for different magnetic field ranges. Black dots show the linearity error derived by considering that the output voltage signal $V_{out}$ varies linearly with the external magnetic field H, $V_{out} \sim c_0 + c_1.H$, (Linear Fit). Open dots show the linearity error derived by considering that the output voltage signal $V_{out}$ is approximated to equation 3:

$$V_{out} \sim [a_0 + a_1 \cdot H - a_3 \cdot H^3] \cdot V_{dd} \qquad \text{Eq. 3.}$$

When the output voltage signal $V_{out}$ is fitted to a linear function (Lin Fit) linearity error increases rapidly with the considered magnetic field range (see dashed lines in Fig.1), reaching values > 1% for magnetic field ranges > 40 mT. Such rapid increase of linearity error, due to the presence of additional high order components on the output voltage signal $V_{out}$, limits the working magnetic field range of such sensors. The ratio between the third order coefficient and the linear coefficient ($a_3/a_1$) will therefore determine the linearity error of the sensor at a fixed magnetic field range or the working field range to obtain a linearity error below a certain value (see Fig. 3a and b). In particular, Fig. 3a shows simulation of linearity error vs $a_3/a_1$ ratio for a magnetic field range of 100 mT, and Fig. 3b shows the maximum magnetic field range in order to have a linearity error < 0.5% vs $a_3/a_1$ ratio.

Although commercial linear magnetic sensors usually work up to 40 mT, there are several applications where either high accuracy linear response might be required (< 0.1%), such as in precise positioning for surgical or aerospace applications, or larger magnetic fields (up to 100 mT) might be involved.

In order to develop a highly-linear magnetic sensor, two different strategies can be considered including developing a different magnetic stack configuration, or developing correction strategies to reduce linearity error of the output voltage signal $V_{out}$. Each strategy has its advantages and disadvantages as summarized in Table 1.

A previous work by the present applicant (International patent application PCT/IB2021/060743) has shown that some linearization correction methods can be implemented on linear magnetic sensors enabling a substantial improvement of linearity error with no loss in sensitivity, such that larger magnetic field ranges can be achieved. The methods rely on the compensation of high order component of the output voltage signal $V_{out}$. The compensation can be achieved either in a piecewise linear or continuous manner.

Table 1 - Comparison of two principal non-linearity correction approaches

|  | advantages | disadvantages |
|---|---|---|
| Magnetic stack development | increase of working magnetic field range<br>simple architecture<br>low noise<br>low power consumption<br>fast response<br>no calibration required | Reduction of sensitivity |
| ASIC development | increase of working magnetic field range<br>no reduction in sensitivity<br>large improvement on linearity<br>potentiality to be implemented in all linear magnetic sensors | increase in power consumption impact on speed potential increase of noise potential calibration required increase of cost / unit additional architecture |

Summary

The present disclosure concerns a correction method for correcting an output voltage signal provided by a magnetic sensor, comprising:

providing a magnetic sensor, comprising at least a magnetic element, and generates the output voltage signal when inputted by a bias voltage and in the presence of an external magnetic field vector;

inputting the magnetic sensor by the bias voltage in the presence of the external magnetic field vector such that the magnetic sensor generates the output voltage signal; and

determining a corrected output voltage signal from the output voltage signal of the magnetic sensor, wherein the corrected output voltage signal has a linearity error smaller than the linearity error of the output voltage signal of the magnetic sensor.

Determining a corrected output voltage signal comprises applying a hyperbolic function or an inverse hyperbolic function or a combination of a hyperbolic function or an inverse hyperbolic function, to a signal proportional to the output voltage signal.

Alternatively, determining a corrected output voltage signal comprises adding or subtracting an additional voltage signal to the output voltage signal, the additional voltage signal being obtained by applying a hyperbolic function or an inverse hyperbolic function or a combination of both to a signal proportional to the output voltage signal.

The present disclosure further concerns an integrated circuit (IC) comprising a processor configured to perform the steps of the method.

The magnetic sensor can comprise a MTJ-based magnetic sensor, i.e., a magnetic sensor based on technologies using magnetic tunnel junctions (MTJs) based on tunnel magneto-resistance (TMR) effect. However, the magnetic sensor can comprise other types of magnetic sensors, such as a GMR- based magnetic sensor, an AMR-based magnetic sensor, a Hall effect-based magnetic sensor, etc. The magnetic sensor can be corrected by the correction method disclosed herein.

The correction method disclosed herein provides higher efficiency against higher order components of the output voltage signal, enabling to correct larger non-linearity errors, allowing the use of the magnetic sensor for larger magnetic field ranges. In other words, non-linear magnetic sensors with high initial sensitivity can be linearized while keeping the same high sensitivity values.

The corrected output voltage signal is relatively insensitive to sample-to-sample, temperature and operating voltage variations. The correction method has increased robustness against device-to-device, operating temperature and voltage variations and allows for improved linearity error correction, without degradation in sensitivity. The correction method can be performed by applying the same parameter set for all devices on a wafer, avoiding time consuming individual calibration procedures for each sensor device that might impact manufacturing cost and reliability performance.

Furthermore, the correction method presented is suitable for real time correction of non-linearity by analog means, thus allow high bandwidth operation. The method can also be applied to linearize the sinusoidal response of 2D magnetic sensors, improving the working angular range of such sensors for auto-focus (AF) applications.

Short description of the drawings

Exemplar embodiments of the invention are disclosed in the description and illustrated by the drawings in which:

Fig. 1 shows an exemplary magnetic sensor;

Fig. 2 shows the linearity error derived from an MTJ based linear sensor for different magnetic field ranges;

Figs. 3a and 3b show simulation of linearity error vs first order coefficient /third order coefficient ratio for a magnetic field range of 100 mT (Fig. 3a) and maximum magnetic field range in order to have a linearity error < 0.5% (Fig. 3b);

Fig. 4 reports the performance of the three hyperbolic correction schemes including Sinh and Arctanh (Fig. 4a and Fig. 4b), and Tanh (Figs. 4c and 4b);

Fig. 5 shows linearity error dependence on the correction parameter for the Sinh scheme (Fig. 5a), Arctanh scheme (Fig. 5b) and Tanh scheme (Fig. 5c);

Fig. 6 reports the variations of the correction parameters around their optimal values for the Sinh scheme (Fig. 6a), Arctanh scheme (Fig. 6b), and Tanh scheme (Fig. 6c);

Fig. 7 shows the corrected output voltage signal and the linearity error of the corrected output voltage signal as a function of the external magnetic field for the Tanh scheme (Fig. 7a and Fig. 7b respectively), for the Sinh, Arctanh, and Tanh correction scheme, and the linearity error as a function of the external magnetic field range for the Sinh, Arctanh, and Tanh correction scheme (Fig. 7c);

Fig. 8 shows the performance of a magnetic sensor, here a 2D angular sensor in a dual full-bridge configuration for the Sinh, Arctanh, and Tanh correction schemes, reporting the corrected output voltage signal as a function of the external magnetic field (Fig. 8a), the linearity error of the corrected output voltage signal as a function of the external magnetic field (Fig. 8b), and the linearity error as a function of the external magnetic field range (Fig. 8c);

Fig.9 shows the dependence of the output voltage signal (Fig. 9a) and linearity error (Fig. 9b) of a magnetic sensor as a function of the magnetic field orientation, according to an embodiment;

Fig. 10 shows the dependence on temperature of the output voltage signal (Fig. 10a) and linearity error (Fig. 10b) of a magnetic sensor as a function of temperature, according to another embodiment;

Fig. 11 reports the performance of the Sinh, Arctanh and Tanh correction schemes for a 2D angular sensor in a dual full-bridge configuration for the temperatures -40°C, 30°C, 85°C and 125°C, where the corrected output voltage signal (Figs. 11a, c and e) and linearity error (Figs. 10b, d and f) are reported for the Sinh correction scheme (Figs. 11a, b), Arctanh correction scheme (Figs. 10b, d), and Tanh correction scheme (Figs. 11e, f); and

Fig. 12 reports the sensitivity (Fig. 12a) and the linearity error (Fig. 12b) as a function of temperature for a 2D angular sensor in a dual full-bridge configuration for the Sinh, Arctanh, and Tanh correction schemes.

Examples of embodiments

A typical voltage response (output voltage signal $V_{out}$) of a magnetic sensor (such as the one shown in Fig. 1) inputted by a bias voltage $V_{dd}$ and under an external magnetic field H can be further described by equation 4:

$$V_{out} = [a_0 + a_1 \cdot H + V_{ho}] \cdot V_{dd} \qquad \text{Eq. 4,}$$

where $V_{out}$ is an output voltage signal of the magnetic sensor, $a_0$ is a sensor offset, $a_1$ is a linear coefficient (or Sensitivity), and $V_{ho}$ is a high order component voltage, expressing the contribution to the output voltage signal $V_{out}$ from all non-linear components. The high order component voltage $V_{ho}$ can be described by equation 5:

$$V_{ho} = \sum_{j=1}^{N}(-1)^j \cdot a_{2j+1} \cdot H^{2j+1} \qquad \text{Eq. 5,}$$

where $a_{2j+1}$ are a high order coefficients.

Alternatively, the output voltage signal $V_{out}$ can be approximated by equation 6:

$$V_{out} = [a_0 + a_1 \cdot \theta + V_{ho}] \cdot V_{dd} \qquad \text{Eq. 6,}$$

where $\theta$ is the orientation of the external magnetic field H with respect to a certain predefined axis in a coordinate system. The high order component voltage $V_{ho}$ can be described by equation 7:

$$V_{ho} = \sum_{j=1}^{N}(-1)^j \cdot a_{2j+1} \cdot \theta^{2j+1} \qquad \text{Eq. 7,}$$

The deviation of the output voltage signal $V_{out}$ from a perfect linear response (so called "linearity error" or "non-linearity") is determined by the amplitude of the high order component voltage $V_{ho}$, which rapidly increases with the amplitude of the applied external magnetic field H which, in turn, causes an increase in linearity error (see Fig. 2). A similar behavior occurs when increasing the orientation $\theta$ of the external magnetic field with respect to a certain predefined axis in a coordinate system.

It will be understood that the magnetic sensor 2 can have a different configuration that the one illustrated in Fig.1. For example, the magnetic sensor 2 can comprise any other number of magnetic sensing elements 20, arranged in a bridge circuit or otherwise. The magnetic sensing element 20 can comprises a magnetoresistive element, such as a MTJ. As discussed above, the magnetic sensing element 20 can comprise other types of magnetic sensing element, such as based on GMR, AMR, Hall effect, etc.

In an embodiment, a method for correcting the output voltage signal $V_{out}$ of at least a magnetic sensor comprises determining a corrected output voltage signal $V_{corr}$ by applying a hyperbolic function or an inverse hyperbolic function or a combination of a hyperbolic function or an inverse hyperbolic function, to a signal proportional to the output voltage $V_{out}$.

In one aspect, a first possible error correction scheme is an Arctanh scheme, where the magnetic sensor is configured to output a corrected output voltage signal $V_{corr}$ that is determined by equation 8:

$$V_{corr} \sim A \cdot arctanh(b \cdot V_{out})$$ Eq. 8a,

where A and b are correction parameters that are independent of the external magnetic field vector H. Note, however that b is the main parameter for such a correction scheme as it determines the linear response of the corrected output voltage $V_{corr}$ while factor $A \cdot b$ determines the desired amplitude of the corrected output voltage $V_{corr}$. A particular example of this correction scheme is determined by Eq. 8b:

$$V_{corr} \sim \gamma \cdot arctanh(V_{out}/\gamma)$$ Eq. 8b,

with A = $\gamma$ and b = 1/$\gamma$ and $\gamma$ are independent of the magnetic field vector H.

A second error correction scheme is a Sinh scheme, where the magnetic sensor is configured to output a corrected output voltage signal $V_{corr}$ that is determined described by equation 9a:

$$V_{corr} \sim A \cdot sinh(b \cdot V_{out})$$ Eq. 9a,

where A and b are correction parameters that are independent of the external magnetic field vector H. Note, however that b is the main parameter for such a correction scheme as it determines the linear response of the corrected output voltage $V_{corr}$ while factor $A \cdot b$ determines the desired amplitude of the corrected output voltage $V_{corr}$. A particular example of this correction scheme is determined by Eq. 9b:

$$V_{corr} \sim \alpha \cdot sinh(V_{out}/\alpha)$$ Eq. 9b,

with $A = \alpha$ and b = 1/$\alpha$ and $\alpha$ are independent of the magnetic field vector H.

A third error correction scheme is a Tanh scheme, where the magnetic sensor is configured to output a corrected output voltage signal $V_{corr}$ that is determined by equation 10a:

$$V_{corr} \sim C \cdot V_{out} - A \cdot tanh(b \cdot V_{out})$$ Eq. 10a

Where A, C and b correction parameters that are independent of the external magnetic field vector H. Note, however that for such a correction scheme all three parameters A, C and b determine both the linear response of the corrected output voltage $V_{corr}$ and the amplitude of the corrected output voltage $V_{corr}$. A particular example of this correction scheme is determined by Eq. 10b:

$$V_{corr} \sim 2 \cdot V_{out} - \beta \cdot tanh(V_{out}/\beta)$$ Eq. 10b,

with $A = \beta$, b = 1/$\beta$ and C = 2 and $\beta$ are independent of the magnetic field vector H.

Note that in this embodiment, the corrected output voltage $V_{corr}$ (in equations 10a and 10b) is determined by adding or subtracting an additional voltage signal $V_{add}$ to the output voltage signal $V_{out}$. The additional voltage signal $V_{add}$ is obtained by applying a hyperbolic function or an inverse hyperbolic function or a combination of both to a signal proportional to the output voltage signal $V_{out}$. In equations 10a and 10b, the second term corresponds to an additional voltage $V_{add}$, namely, $V_{add} = A \cdot tanh(b \cdot V_{out})$ and $V_{add} = \beta \cdot tanh(V_{out}/\beta)$, respectively.

For such particular correction schemes (described by Eq. 8b, 9b and 10b), fine tuning correction parameters $\gamma$, $\alpha$ and $\beta$ allows for obtaining a corrected output voltage $V_{corr} \sim (a_0 + a_1 \cdot H) \cdot V_{dd}$.

Other hyperbolic functions can also be used in the error correction scheme. For example, another error correction scheme can comprise a Cosh scheme, where the magnetic sensor is configured to output a corrected output voltage signal $V_{corr}$ that is determined by equation 11:

$$V_{corr} = A \cdot cosh(b \cdot V_{out}) \qquad\qquad \text{Eq. 11,}$$

where A and b are correction parameters independent of the magnetic field vector H.

Yet another error correction scheme can comprise a combination of a hyperbolic function and an inverse hyperbolic function scheme, where the magnetic sensor is configured to output a corrected output voltage signal $V_{corr}$ that is determined by equation 12:

$$V_{corr} = C \cdot \tanh(A \cdot \operatorname{arctanh}(b \cdot V_{out})) \qquad\qquad \text{Eq. 12,}$$

where A, C and b are correction parameters independent of the magnetic field vector H.

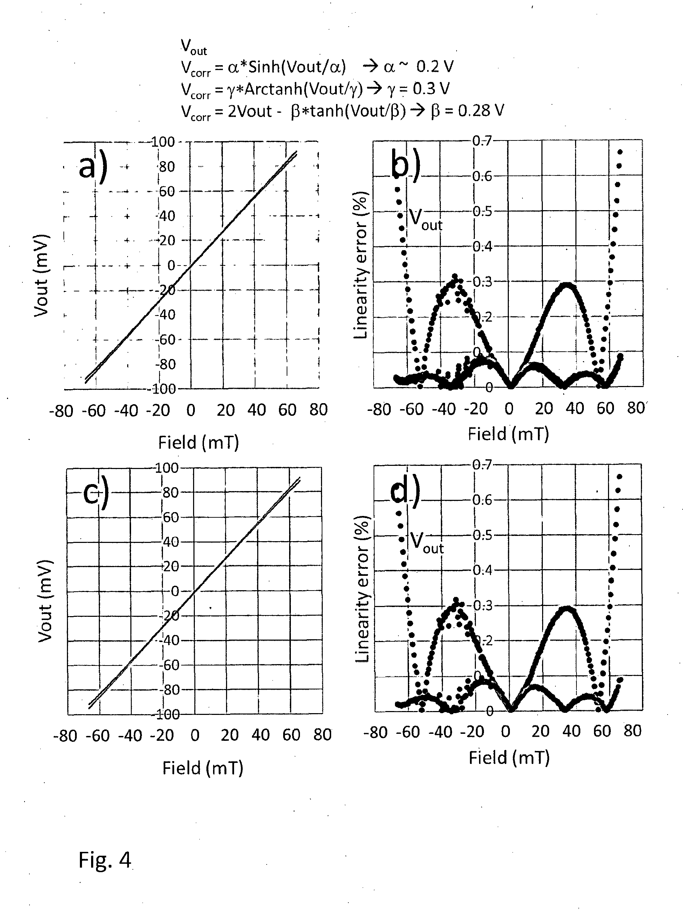

Fig. 4 reports the performance of the three hyperbolic correction schemes Arctanh, Sinh and Tanh, on improving linearity error of the magnetic sensor when the bias voltage $V_{dd}$ = 1V. More particularly, Fig. 4a shows the corrected output voltage signal $V_{corr}$ following the Arctanh scheme (Eq. 8b) and Sinh scheme (Eq. 9b) as a function of the external magnetic field H. Fig. 4b reports the linearity error of the corrected output voltage signal $V_{corr}$ following the Arctanh scheme (Eq.8b) and the Sinh scheme (Eq. 9b) as a function of the external magnetic field H. Fig. 4c shows the corrected output voltage signal $V_{corr}$ following the Tanh scheme (Eq. 10b) as a function of the external magnetic field H, and Fig. 4d reports the linearity error of the corrected output voltage signal $V_{corr}$ following the Tanh scheme (Eq. 10b) as a function of the external magnetic field H. In Figs 4a to 4d, the corrected output voltage signal $V_{corr}$ and the linearity error are compared with the output voltage signal $V_{out}$ and the linearity error of output voltage signal $V_{out}$.

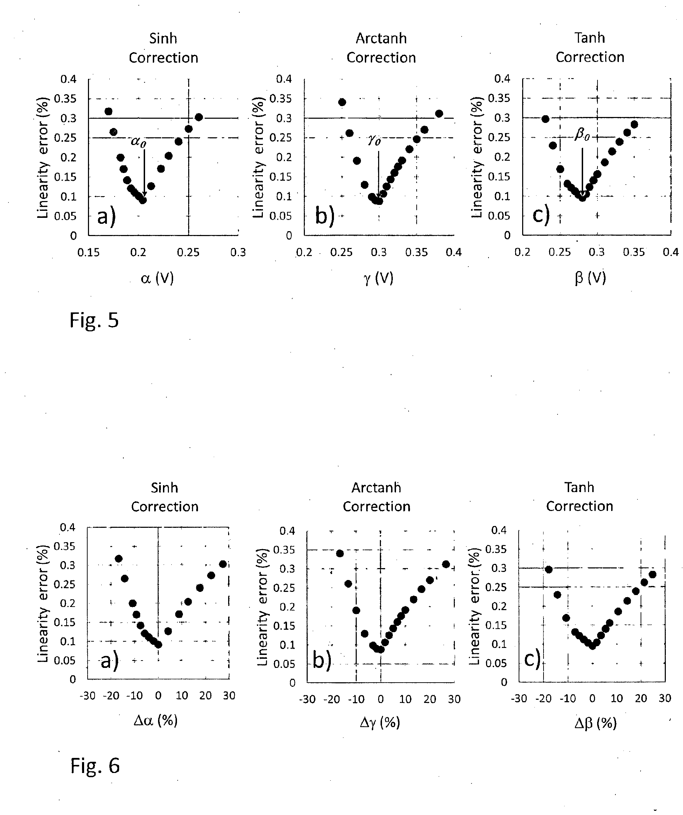

The correction schemes of equations 8b, 9b and 10b show high robustness against correction parameter variability. For example, Fig. 5 shows linearity error dependence on the correction parameter $\gamma$, $\alpha$ and $\beta$ for each correction scheme for the magnetic sensor when submitted to an external magnetic field up to 67 mT and a bias voltage $V_{dd}$ of 1V. In particular, Fig. 5a reports linearity error dependence for the Sinh scheme, Fig. 5b reports linearity error dependence for the Arctanh scheme, and Fig. 5c reports linearity error dependence for the Tanh scheme. Note that the minimum linearity error is obtained for optimal values of the correction parameters, denoted $\alpha_0$, $\gamma_0$ and $\beta_0$ in Fig. 5.

Fig 6 reports the variations $\Delta\alpha$, $\Delta\gamma$ and $\Delta\beta$ of the correction parameters $\gamma$, $\alpha$ and $\beta$, respectively, around their optimal values $\alpha_0$, $\gamma_0$ and $\beta_0$ for the Sinh scheme described by Eq. 9b (Fig. 6a), the Arctanh scheme describe by Eq. 8b (Fig. 6b), and the Tanh scheme described by Eq. 10b (Fig. 6c). Fig. 6 shows that for a variation of correction parameters of about $\pm 10\%$ around its optimal values $\alpha_0$, $\gamma_0$ and $\beta_0$, linearity errors smaller than about 0.2% are obtained.

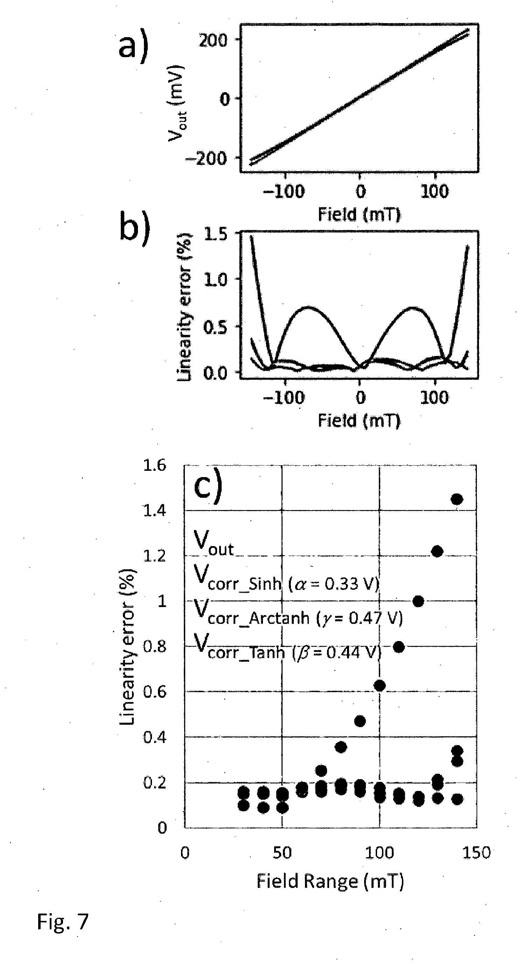

Fig. 7 shows the corrected output voltage signal $V_{corr}$ and the linearity error of the corrected output voltage signal $V_{corr}$ for a magnetic sensor under external magnetic fields H up to 140 mT. In particular, Fig. 7a reports the corrected output voltage signal $V_{corr}$ following the Arctanh scheme (Eq. 8b), the Sinh scheme (Eq. 9b) and Tanh scheme (Eq. 10b) as a function of the external magnetic field H. Fig. 7b reports the linearity error of the corrected output voltage signal $V_{corr}$ for the Arctanh, Sinh, and Tanh correction scheme (Equations 8b, 9b and 10b, respectively) as a function of the external magnetic field H. Fig. 7c reports the linearity error as a function of the external magnetic field range for the Arctanh, Sinh, and Tanh correction scheme (Equations 8b, 9b and 10b, respectively). In Figs 7a to 7c, the correction parameters $\alpha$ = 0.33 V, $\gamma$ = 0.47 V and $\beta$ = 0.44 V were used. The corrected output voltage signal $V_{corr}$ and its linearity error are compared with the output voltage signal $V_{out}$ the linearity error of output voltage signal $V_{out}$.

Depending on the case, the Arctanh, Sinh, and Tanh correction schemes provide similar corrected output voltage signals $V_{corr}$. However, in some situations the Arctanh correction scheme can perform better than Sinh and Tanh correction schemes.

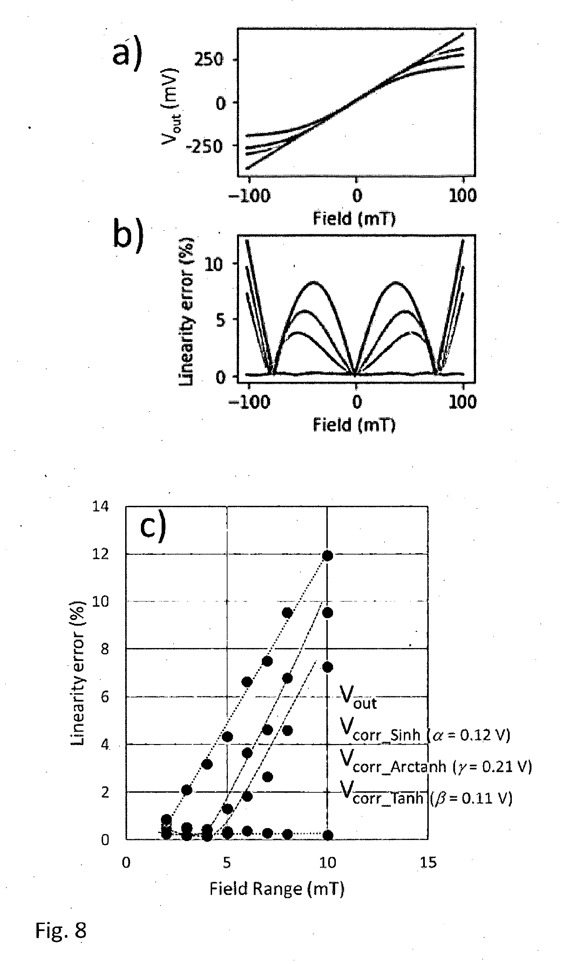

Fig. 8 shows the performance of a magnetic sensor, here a 2D angular sensor, for the Arctanh, Sinh, and Tanh correction schemes determined by Equations 8b, 9b and 10b, respectively, and for external magnetic fields up to 10 mT. In particular, Fig. 8a reports the corrected output voltage signal $V_{corr}$ as a function of the external magnetic field H, Fig. 8b reports the linearity error of the corrected output voltage signal $V_{corr}$ as a function of the external magnetic field H, and Fig. 8c reports the linearity error as a function of the external magnetic field range. For this, the correction parameters $\gamma$ = 0.21 V, $\alpha$ = 0.12 V and $\beta$ = 0.11 V were used for Arctanh, Sinh and Tanh correction scheme respectively.

For an external magnetic field range up to 10 mT, the output voltage signal $V_{out}$ shows a large non-linear response as shown by black curve in Fig. 8a with a high linearity error > 10%. Indeed, such magnetic sensor only shows good linear performance (Linearity error < 1%) at magnetic fields smaller than 1 mT (see Fig. 8c).

However, using Tanh or Sinh correction schemes allows for obtaining corrections linearity error smaller than 1% at magnetic field ranges up to 5 mT. When using the arctanh correction scheme a linearity error < 0.3% is obtained for magnetic field ranges up to 10 mT.

This shows the advantage of using the Arctanh, Sinh, or Tanh correction schemes for obtaining a magnetic sensor having a very high Sensitivty (up to 40mV/V/mT) and very low linearity error ( < 0.3%) for fields up to 10 mT.

In one aspect, the output voltage $V_{out}$ is approximated by equation 4 or by equation 6.

Previously described correction schemes are specific embodiments for linearity correction of magnetic sensors with output voltages described, up to a 3$^{rd}$ order approximation, by:

$$V_{out} \sim [a_0 + a_1 \cdot H - a_3 \cdot H^3] \cdot V_{dd} \qquad \text{Eq. 14a,}$$

or by:

$$V_{out} \sim [a_0 + a_1 \cdot \theta - a_3 \cdot \theta^3] \cdot V_{dd} \qquad \text{Eq. 14b.}$$

However, yet another error correction schemes based on hyperbolic functions and inverse hyperbolic functions could be used for different dependence of the $V_{out}$ with respect to the magnetic field vector H.

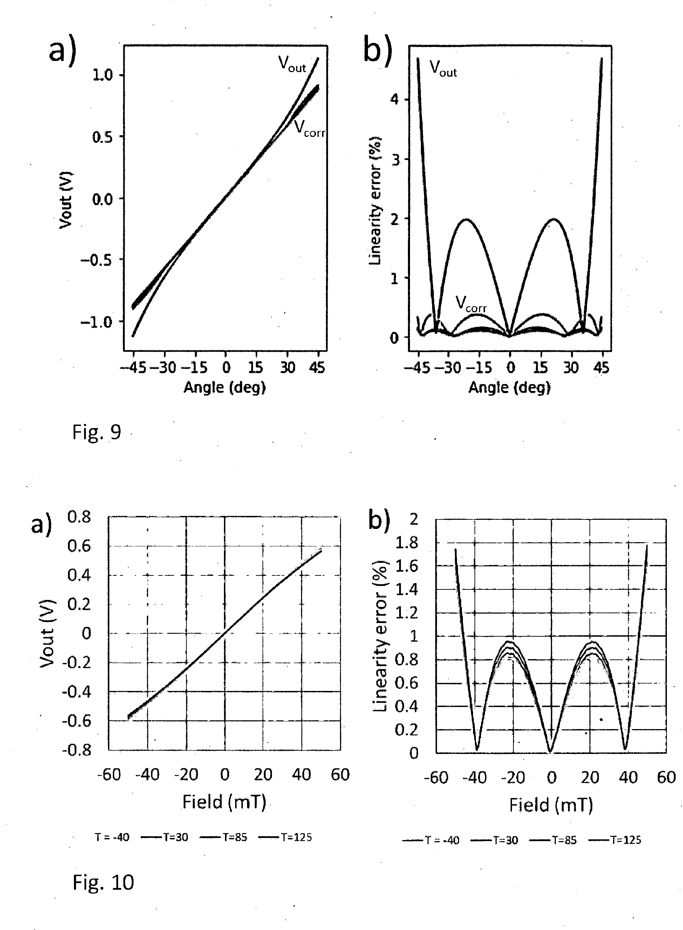

Fig. 9 shows the dependence of the output voltage signal (Fig. 9a) and linearity error (Fig. 9b) of a magnetic sensor as a function of the magnetic field orientation $\theta$ with an output voltage described by:

$$V_{out} \sim [a_0 + a_1 \cdot \theta + a_3 \cdot \theta^3] \cdot V_{dd} \qquad \text{Eq.15}$$

For this situation different schemes than previously proposed (Eq. 8, 9 and 10) need to be considered.

At such conditions, a corrected output voltage signal $V_{corr}$ based on a Tanh function can be obtained by equation 16a:

$$V_{corr} \sim A \cdot tanh(b \cdot V_{out}) \qquad \text{Eq. 16a,}$$

where A and b are correction parameters that are independent of the external magnetic field vector H. Note, however that b is the main parameter for such a correction scheme as it determines the linear response of the corrected output voltage $V_{corr}$ while factor $A \cdot b$ determines the desired amplitude of the corrected output voltage $V_{corr}$. A particular example of this correction scheme is determined by Eq. 16b:

$$V_{corr} \sim \beta \cdot tanh(V_{out}/\beta) \qquad \text{Eq. 16b.}$$

with $A = \beta$, $b = 1/\beta$ and $\beta$ are independent of the magnetic field vector H.

Similarly, output voltage $V_{out}$ of Fig. 9 can be linearized by a Sinh correction scheme leading to a corrected output voltage signal $V_{corr}$ described by Eq. 17a:

$$V_{corr} = C \cdot V_{out} - A \cdot \sinh(b \cdot V_{out}) \qquad \text{Eq.17a,}$$

where A, C and b are correction parameters that are independent of the external magnetic field vector H. Note, however that for such a correction scheme all three parameters A, C and b determine both the linear response of the corrected output voltage $V_{corr}$ and the amplitude of the corrected output voltage $V_{corr}$. A particular example of this correction scheme is determined by Eq. 17b:

$$V_{corr} = 2 \cdot V_{out} - \alpha \cdot \sinh (V_{out}/\alpha) \qquad \text{Eq. 17b,}$$

with $A = \alpha$, b = $1/\alpha$ and $\alpha$ are independent of the magnetic field vector H.

In equations 17a and 17b, the second term corresponds to an additional voltage $V_{add}$, namely, $V_{add} = A \cdot \sinh(b \cdot V_{out})$ and $V_{add} = \alpha \cdot \sinh (V_{out}/\alpha)$, respectively.

In yet another embodiment, output voltage $V_{out}$ of Fig. 9 can be linearized by a Arcsinh correction scheme leading to a corrected output voltage signal $V_{corr}$ described by Eq. 18a:

$$V_{corr} = A \cdot \text{arcsinh} (b \cdot V_{out}) \qquad \text{Eq.18a,}$$

where A and b are correction parameters that are independent of the external magnetic field vector H. Note, however that b is the main parameter for such a correction scheme as it determines the linear response of the corrected output voltage $V_{corr}$ while factor $A \cdot b$ determines the desired amplitude of the corrected output voltage $V_{corr}$. A particular example of this correction scheme is determined by Eq. 18b:

$$V_{corr} = \omega \cdot \text{arcsinh} (b V_{out}/\omega) \qquad \text{Eq.18b,}$$

with $A = \omega$, b = $1/\omega$ and $\omega$ are independent of the magnetic field vector H.

Fig. 9 shows the result of these correction schemes (Eq. 16b, 17b and 18b) in order to obtain a corrected output voltage $V_{corr}$ with linearity error < 0.4%. For this, the correction parameters $\alpha$ = 1.07 V, $b$ = 1.23 V and $\omega$ = 0.69 V were used. The corrected output voltage signal $V_{corr}$ and its linearity error are compared with the output voltage signal $V_{out}$ the linearity error of output voltage signal $V_{out}$. Note that linearity error is reduced from 4.6% up to a 0.11% (which is a x 40 reduction).

In another aspect, the corrected output voltage $V_{corr}$ is determined by equation 19:

$$V_{corr} = C \cdot V_{out} - A \cdot \text{arctanh} (b \cdot V_{out}) \qquad \text{Eq.19,}$$

where A, C and b are correction parameters that are independent of the external magnetic field vector H. Note, however that for such a correction scheme all three parameters A, C and b determines both the linear response of the corrected output voltage $V_{corr}$ and the amplitude of the corrected output voltage $V_{corr}$.

In another aspect, the corrected output voltage $V_{corr}$ is determined by equation 20:

$$V_{corr} = C \cdot V_{out} - A \cdot \cosh (b \cdot V_{out}) \qquad \text{Eq. 20,}$$

where A, C and b are correction parameters that are independent of the external magnetic field vector H. Note, however that for such a correction scheme all three parameters A, C and b determine both the linear response of the corrected output voltage $V_{corr}$ and the amplitude of the corrected output voltage $V_{corr}$.

In yet another aspect, the corrected output voltage $V_{corr}$ is determined by equation 21:

$$V_{corr} = D \cdot V_{out} - C \cdot \tanh (A \cdot \text{arctanh} (b \cdot V_{out})) \qquad \text{Eq. 21,}$$

wherein A, C and D are correction parameters that are independent of the external magnetic field vector H.

The present disclosure further pertains to an integrated circuit (IC) comprises a processor configured to perform the steps of the method disclosed herein. In some aspects, the IC can comprise an application-specific integrated circuit (ASIC) die.

The present disclosure further pertains an intellectual property (IP) block configured to perform the method disclosed herein.

*Temperature dependence*

Fig. 10 shows the dependence on temperature of the output voltage signal $V_{out}$ (Fig. 109a) and linearity error (Fig. 10b) of a magnetic sensor as a function of temperature. The magnetic sensor is a 2D angular sensor and the output voltage signal $V_{out}$ and linearity error were determined at -40°C, 30°C, 85°C and 125°C under external magnetic fields H up to 50 mT and using a bias voltage $V_{dd}$ of 3.3V. Linearity errors between about 1.6% and 1.8% are obtained at all temperatures and a temperature coefficient of sensitivity (TCS) of about - 420 ppm/°C. This implies a variation of Sensitivity of about 7.5% over the whole temperature range [-40°C - 125°C].

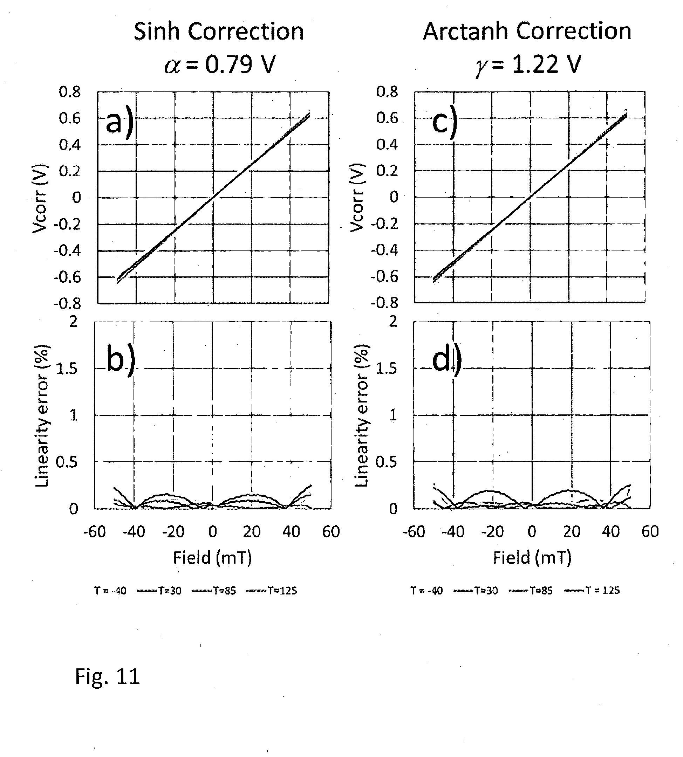

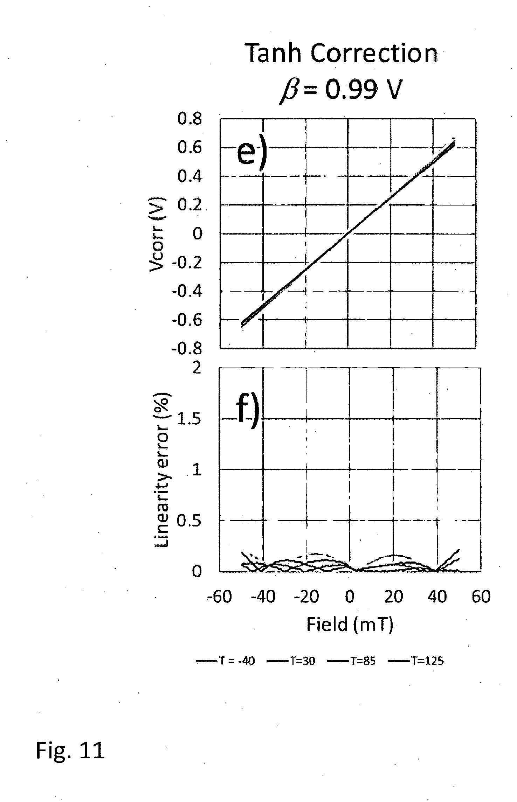

Fig. 11 reports the performance of the Arctanh, Sinh, and Tanh correction schemes for the2D angular sensor for the temperatures -40°C, 30°C, 85°C and 125°C and for optimal values of the correction parameters $\alpha$ = 0.79 V, $\gamma$ = 1.22 V, and $\beta$ = 0.99 V when biased at 3.3 V. In particular, the corrected output voltage signal $V_{corr}$ (Figs. 11a, c and e) and linearity error (Figs. 11b, d and f) are reported for the Sinh correction scheme (Figs. 11a, b), Arctanh correction scheme (Figs. 11b, d), and Tanh correction scheme (Figs. 11e, f). A linearity error smaller than 0.3% is obtained for all temperatures.

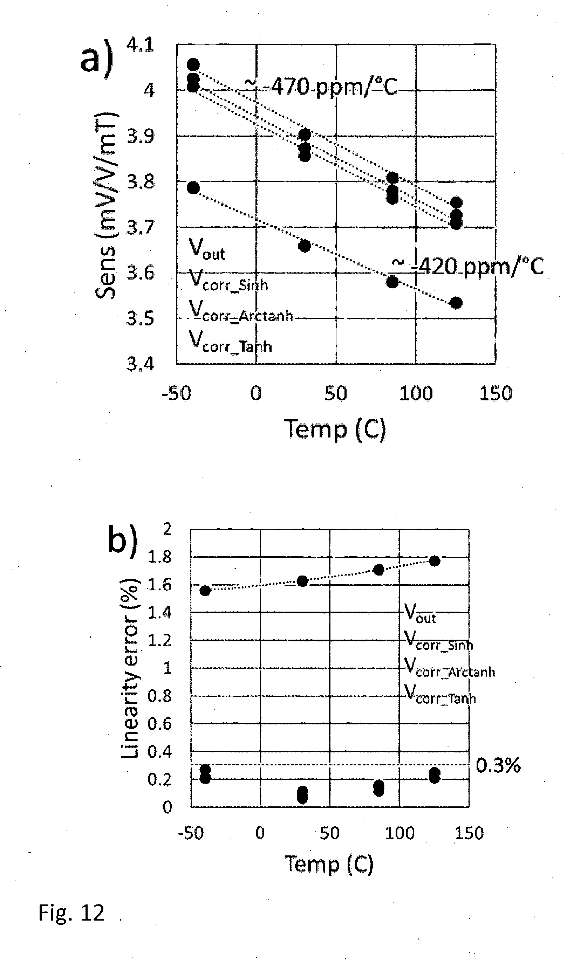

Fig. 12 reports the sensitivity (Fig. 12a) and the linearity error (Fig. 12b) as a function of temperature for the 2D angular sensor for the correction parameters $\alpha$ = 0. 79V, $\gamma$ = 1.22 V, and $\beta$ = 0.99V for the Sinh, Arctanh, and Tanh correction schemes, respectively. After correction, the variation of Sensitivity with temperature, TCS is about -470 ppm/°C, which is very similar to the initial TCS of about -420 ppm/°C of the (uncorrected) output voltage signal $V_{out}$.

The results shown show the potential of the Arctanh, Sinh, and Tanh correction schemes and their robustness against temperature. However, other hyperbolic functions could be used for different dependence of the output voltage signal $V_{out}$ with respect to the external magnetic field H.

In an embodiment, correcting the output voltage signal $V_{out}$ can further comprise a correction of the TCS such as to further improve the linearity of the corrected output voltage signal $V_{corr}$ of the magnetic sensor and obtain a magnetic sensor that has a stable sensitivity and linearity error with varying temperature.

**Reference numbers and symbols**

| | |
|---|---|
| 2 | magnetic sensor |
| 20 | magnetic sensing element |
| $\theta$ | orientation of the external magnetic field |
| $\gamma$, $\alpha$ and $\beta$ | correction parameters |
| $\nu_s$ | dependence on magnetic field of a normalized output voltage |
| $a_0$ | sensor offset |
| $a_1$ | linear coefficient |
| $a_{2j+1}$ | high order component |
| $a_3$ | third order coefficient |
| H | external magnetic field |
| $V_{add}$ $V_{corr}$ | corrected output voltage signal |
| $V_{dd}$ | bias voltage |
| $V_{ho}$ | high order component voltage |
| $V_{out}$ | output voltage signal |

**Claims**

**1.** A correction method for correcting an output voltage signal ($V_{out}$) provided by a magnetic sensor (2), comprising:

providing a magnetic sensor (2), comprising at least a magnetic element (20), and generates the output voltage signal ($V_{out}$) when inputted by a bias voltage ($V_{dd}$) and in the presence of an external magnetic field vector (H); inputting the magnetic sensor (2) by the bias voltage ($V_{dd}$) in the presence of the external magnetic field vector (H) such that the magnetic sensor (2) generates the output voltage signal ($V_{out}$); and

determining a corrected output voltage signal ($V_{corr}$) from the output voltage signal ($V_{out}$) of the magnetic sensor, wherein the corrected output voltage signal ($V_{corr}$) has a linearity error smaller than the linearity error of the output voltage signal ($V_{out}$) of the magnetic sensor;

**characterized in that**

determining a corrected output voltage signal ($V_{corr}$) comprises:

applying a hyperbolic function or an inverse hyperbolic function or a combination of a hyperbolic function or an inverse hyperbolic function, to a signal proportional to the output voltage signal ($V_{out}$); or

adding or subtracting an additional voltage signal ($V_{add}$) to the output voltage signal ($V_{out}$), the additional voltage signal ($V_{add}$) being obtained by applying a hyperbolic function or an inverse hyperbolic function or a combination of both to a signal proportional to the output voltage signal ($V_{out}$).

2. The correction method according to claim 1, wherein determining a corrected output voltage signal ($V_{corr}$) comprises applying a hyperbolic function or an inverse hyperbolic function or a combination of a hyperbolic function or an inverse hyperbolic function, to a signal proportional to the output voltage signal ($V_{out}$).

3. The correction method according to claim 2, wherein the output voltage signal ($V_{out}$) is approximated by:

$$V_{out} = [a_0 + a_1 \cdot H + V_{ho}] \cdot V_{dd};$$

wherein $a_0$ is an offset coefficient, $a_1$ is a first order coefficient and $V_{ho}$ is the high order component described by:

$$V_{ho} = \sum_{j=1}^{N} a_{2j+1} \cdot H^{2j+1};$$

wherein $a_{2j+1}$ are high order coefficients and the coefficients $a_0$, $a_1$ and $a_{2j+1}$ can be either positive, negative or zero.

4. The correction method according to claim 2, wherein the output voltage signal ($V_{out}$) is approximated by:

$$V_{out} = [a_0 + a_1 \cdot \theta + V_{ho}] \cdot V_{dd};$$

wherein $\theta$ is the orientation of the external magnetic field H with respect to a certain predefined axis in a coordinate system, $V_{dd}$ is the bias voltage applied to the sensor, $a_0$ is an offset coefficient, $a_1$ is a first order coefficient and $V_{ho}$ is the high order component described by:

$$V_{ho} = \sum_{j=1}^{N} a_{2j+1} \cdot \theta^{2j+1};$$

wherein $a_{2j+1}$ are high order coefficients and the coefficients $a_0$, $a_1$ and $a_{2j+1}$ can be either positive, negative or zero.

5. The correction method according to any of claims 2 to 4, wherein the corrected output voltage ($V_{corr}$) is determined by:

$$V_{corr} = A \cdot \sinh(b \cdot V_{out});$$

wherein A and b are correction parameters independent of the magnetic field vector (H).

6. The correction method according to any of claims 2 to 4, wherein the corrected output voltage ($V_{corr}$) is determined by:

$$V_{corr} = A \cdot \cosh\left(b \cdot V_{out}\right);$$

wherein *A* and *b* are correction parameters independent of the magnetic field vector (H).

7. The correction method according to any of claims 2 to 4, wherein the corrected output voltage ($V_{corr}$) is determined by:

$$V_{corr} = A \cdot \tanh\left(b \cdot V_{out}\right);$$

wherein A and b are correction parameters independent of the magnetic field vector (H).

8. The correction method according to any of claims 2 to 4, wherein the corrected output voltage ($V_{corr}$) is determined by:

$$V_{corr} = A \cdot \operatorname{arctanh}\left(b \cdot V_{out}\right);$$

wherein A and b are correction parameters independent of the magnetic field vector (H).

9. The correction method according to any of claims 2 to 4, wherein the corrected output voltage ($V_{corr}$) is determined by:

$$V_{corr} = A \cdot \operatorname{arcsinh}\left(b \cdot V_{out}\right);$$

wherein A and b are correction parameters independent of the magnetic field vector (H).

10. The correction method according to any of claims 2 to 4, wherein the corrected output voltage ($V_{corr}$) is determined by:

$$V_{corr} = C \cdot \tanh\left(A \cdot \operatorname{arctanh}\left(b \cdot V_{out}\right)\right);$$

wherein *A*, *C* and *b* are correction parameters independent of the magnetic field vector (H).

11. The correction method according to claim 1,
wherein determining a corrected output voltage signal ($V_{corr}$) comprises adding or subtracting an additional voltage signal ($V_{add}$) to the output voltage signal ($V_{out}$), the additional voltage signal ($V_{add}$) being obtained by applying a hyperbolic function or an inverse hyperbolic function or a combination of both to a signal proportional to the output voltage signal ($V_{out}$),

12. The correction method according to claim 11,
wherein the output voltage signal ($V_{out}$) is approximated by:

$$V_{out} = \left[a_0 + a_1 \cdot H + V_{ho}\right] \cdot V_{dd};$$

wherein $a_0$ is an offset coefficient, $a_1$ is a first order coefficient and $V_{ho}$ is the high order component described by:

$$V_{ho} = \sum_{j=1}^{N} a_{2j+1} \cdot H^{2j+1};$$

wherein $a_{2j+1}$ are high order coefficients and the coefficients ao, $a_1$ and $a_{2j+1}$ can be either positive, negative or zero.

13. The correction method according to claim 11, wherein the output voltage signal ($V_{out}$) is approximated by:

$$V_{out} = [a_0 + a_1 \cdot \theta + V_{ho}] \cdot V_{dd};$$

wherein $\theta$ is the orientation of the external magnetic field H with respect to a certain predefined axis in a coordinate system, $V_{dd}$ is the bias voltage applied to the sensor, $a_0$ is an offset coefficient, $a_1$ is a first order coefficient and $V_{ho}$ is the high order component described by:

$$V_{ho} = \sum_{j=1}^{N} a_{2j+1} \cdot \theta^{2j+1};$$

wherein $a_{2j+1}$ are high order coefficients and the coefficients ao, $a_1$ and $a_{2j+1}$ can be either positive, negative or zero.

14. The correction method according to any of claims 11 to 13, wherein the corrected output voltage ($V_{corr}$) is determined by:

$$V_{corr} = C \cdot V_{out} - A \cdot \sinh\left(b \cdot V_{out}\right);$$

wherein *A, C* and *b* are correction parameters independent of the magnetic field vector (H).

15. The correction method according to any of claims 10 to 13, wherein the corrected output voltage ($V_{corr}$) is determined by:

$$V_{corr} = C \cdot V_{out} - A \cdot \cosh\left(b \cdot V_{out}\right);$$

wherein A, C and b are correction parameters independent of the magnetic field vector (H).

16. The correction method according to any of claims 11 to 13, wherein the corrected output voltage ($V_{corr}$) is determined by:

$$V_{corr} = C \cdot V_{out} - A \cdot \tanh\left(b \cdot V_{out}\right);$$

Wherein *A, C* and *b* are correction parameters independent of the magnetic field vector (H).

17. The correction method according to any of claims 11 to 13, wherein the corrected output voltage ($V_{corr}$) is determined by:

$$V_{corr} = C \cdot V_{out} - A \cdot \operatorname{arctanh}\left(b \cdot V_{out}\right);$$

wherein *A, C* and *b* are correction parameters independent of the magnetic field vector (H).

18. The correction method according to any of claims 11 to 13, wherein the corrected output voltage ($V_{corr}$) is determined by:

$$V_{corr} = C \cdot V_{out} - A \cdot \operatorname{arcsinh}\left(b \cdot V_{out}\right);$$

wherein *A, C* are and *b* are correction parameters independent of the magnetic field vector (H).

19. The correction method according to any of claims 10 to 12, wherein the corrected output voltage ($V_{corr}$) is determined by:

$$V_{corr} = D \cdot V_{out} - C \cdot \tanh\left(A \cdot \text{arctanh}\left(b \cdot V_{out}\right)\right);$$

wherein *A, C* and *D* and *b* are correction parameters independent of the magnetic field vector (H).

**20.** The correction method according to any of claims 1 to 19, wherein the magnetic sensor (2) is a MTJ-based magnetic sensor (2) comprising at least a magnetoresistive element (20).

**21.** A integrated circuit (IC) comprising a processor configured to perform the steps of the method of claims 1 to 20.

**22.** An intellectual property (IP) block configured to perform the method of any of claims 1 to 20.

$V_{dd}$

A

20

C

D

$V_{out+}$

2

B

$V_{out-}$

$V_{out} = V_{out+} - V_{out-}$

Fig. 1

Fig. 2

Fig. 3

$V_{out}$

$V_{corr} = \alpha * Sinh(Vout/\alpha) \rightarrow \alpha \sim 0.2\,V$

$V_{corr} = \gamma * Arctanh(Vout/\gamma) \rightarrow \gamma = 0.3\,V$

$V_{corr} = 2Vout - \beta * tanh(Vout/\beta) \rightarrow \beta = 0.28\,V$

Fig. 4

Fig. 5

Fig. 6

Fig. 7

a)

b)

c)

$V_{out}$

$V_{corr\_Sinh}$ ($\alpha$ = 0.12 V)

$V_{corr\_Arctanh}$ ($\gamma$ = 0.21 V)

$V_{corr\_Tanh}$ ($\beta$ = 0.11 V)

Fig. 8

Fig. 9

Fig. 10

Fig. 11

Fig. 11

Fig. 12

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/045989 A1 (ESUMI ATSUSHI [JP] ET AL) 19 February 2009 (2009-02-19) * paragraphs [0376] - [0428]; figures 29-32C * | 1-22 | INV. G01R33/00 |
| X | XIAODONG ZHAO ET AL: "The error compensation for static hysteresis characteristics of Giant Magneto-Resistance sensor", 2016 IEEE SENSORS APPLICATIONS SYMPOSIUM (SAS), IEEE, 20 April 2016 (2016-04-20), pages 1-5, XP032905808, DOI: 10.1109/SAS.2016.7479901 [retrieved on 2016-05-26] * abstract, section IV * | 1-22 | |
| X | JP 2001 343439 A (TOKIN CORP) 14 December 2001 (2001-12-14) * paragraphs [0009], [0044] - [0075]; figure 6 * | 1-19,21, 22 | |

TECHNICAL FIELDS
SEARCHED (IPC)

G01R

The present search report has been drawn up for all claims

| Place of search | Date of completion of the search | Examiner |
|---|---|---|
| Munich | 3 January 2023 | Philipp, Peter |

**ANNEX TO THE EUROPEAN SEARCH REPORT
ON EUROPEAN PATENT APPLICATION NO.**

EP 22 31 5164

This annex lists the patent family members relating to the patent documents cited in the above-mentioned European search report.
The members are as contained in the European Patent Office EDP file on
The European Patent Office is in no way liable for these particulars which are merely given for the purpose of information.

03-01-2023

| Patent document cited in search report | Publication date | Patent family member(s) | | Publication date |
|---|---|---|---|---|
| US 2009045989 A1 | 19-02-2009 | KR | 20080096745 A | 03-11-2008 |
| | | TW | 200746090 A | 16-12-2007 |
| | | US | 2009045989 A1 | 19-02-2009 |
| | | WO | 2007083525 A1 | 26-07-2007 |
| JP 2001343439 A | 14-12-2001 | NONE | | |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US IB2021060743 W